(19) Europäisches Patentamt
European Patent Office
Office européen des brevets

(11) **EP 2 047 527 B1**

(12) **EUROPÄISCHE PATENTSCHRIFT**

(45) Veröffentlichungstag und Bekanntmachung des Hinweises auf die Patenterteilung:
**22.11.2017 Patentblatt 2017/47**

(21) Anmeldenummer: **07817415.8**

(22) Anmeldetag: **27.07.2007**

(51) Int Cl.:
*H01L 33/00* (2010.01)      *H01L 33/06* (2010.01)
*H01L 33/30* (2010.01)      *H01L 33/46* (2010.01)
*B82Y 20/00* (2011.01)

(86) Internationale Anmeldenummer:
**PCT/DE2007/001349**

(87) Internationale Veröffentlichungsnummer:
**WO 2008/014772 (07.02.2008 Gazette 2008/06)**

(54) **LED-HALBLEITERKÖRPER**

LED SEMICONDUCTOR BODY

CORPS SEMI-CONDUCTEUR DE DEL

(84) Benannte Vertragsstaaten:
**DE**

(30) Priorität: **31.07.2006 DE 102006035627**

(43) Veröffentlichungstag der Anmeldung:
**15.04.2009 Patentblatt 2009/16**

(73) Patentinhaber: **OSRAM Opto Semiconductors GmbH**
**93055 Regensburg (DE)**

(72) Erfinder:
• **GRÖNNINGER, Günther**
**92358 Seubersdorf (DE)**
• **JUNG, Christian**
**93188 Pielenhofen (DE)**
• **HEIDBORN, Peter**
**93197 Zeitlarn (DE)**
• **BEHRES, Alexander**
**93309 Kelheim (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**EP-A- 0 731 511**      **US-A- 6 020 601**
**US-A1- 2004 017 835**      **US-A1- 2005 161 699**

• ZHANG G ET AL: "STRAIN-COMPENSATED INGAAS/GAASP/GAINASP/GAINP QUANTUM WELL LASERS ( ~0.98 UM) GROWN BY GAS-SOURCE MOLECULAR BEAM EPITAXY" APPLIED PHYSICS LETTERS, AIP, AMERICAN INSTITUTE OF PHYSICS, MELVILLE, NY, US, Bd. 62, Nr. 14, 5. April 1993 (1993-04-05), Seiten 1644-1646, XP000355014 ISSN: 0003-6951
• MITCHELL C J ET AL: "Material characterization of highly strained and partially strain compensated InxGa1-xAs/InyAl1-yAs quantum cascade light emitting diodes grown by mbe for emission in the near infrared (2-4/spl mu/m)" ELECTRON DEVICES FOR MICROWAVE AND OPTOELECTRONIC APPLICATIONS, 2002. EDMO 2002. THE 10TH IEEE INTERNATIONAL SYMPOSIUM ON 18-19 NOV. 2002, PISCATAWAY, NJ, USA,IEEE, 18. November 2002 (2002-11-18), Seiten 8-13, XP010625920 ISBN: 0-7803-7530-0

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen LED-Halbleiterkörper, der zur Erzeugung von Strahlung vorgesehen ist.

Diese Patentanmeldung beansprucht die Priorität der deutschen Patentanmeldung 10 2006 035 627.6, deren Offenbarungsgehalt hiermit durch Rückbezug aufgenommen wird.

In LED-Halbleiterkörpern liegt die interne Quanteneffizienz, also das Verhältnis von im Halbleiterkörper erzeugten Photonen zu den in den Halbleiterkörper injizierten Elektron-Loch-Paaren, oftmals deutlich unter dem Idealwert von 1.

In der Druckschrift US 2004/0017835 A1 wird beschrieben, dass die Peak-Übergangsenergien in InGaAs/GaAs-Heterostrukturen unter anderem durch eine Verspannungskompensation zur Erhöhung der Schichtdicke in Quantentöpfen mit hinreichend hohem Indium-Gehalt verringert werden können.

Der Erfindung liegt die Aufgabe zugrunde einen LED-Halbleiterkörper mit verbesserten Eigenschaften anzugeben. Insbesondere soll die interne Quanteneffizienz gesteigert und die spektrale Breite der im Betrieb des LED-Halbleiterkörpers abgestrahlten Strahlung verringert werden. Weiterhin soll die Linearität der Leistung der abgestrahlten Strahlung bezüglich des Betriebsstroms bei hohen Betriebsströmen verbessert werden.

Diese Aufgabe wird mit einem LED-Halbleiterkörper mit den Merkmalen des unabhängigen Patentanspruchs 1 gelöst.

Der erfindungsgemäße LED-Halbleiterkörper weist eine Halbleiterschichtenfolge auf, die eine zur Erzeugung von inkohärenter Strahlung vorgesehene Quantenstruktur mit mindestens einer Quantenschicht und mindestens einer Barriereschicht umfasst. Dabei sind die Quantenschicht und die Barriereschicht mit zueinander entgegengesetzten Vorzeichen verspannt.

Da die Barriereschicht eine Verspannung aufweist, die ein der Verspannung der Quantenschicht entgegengesetztes Vorzeichen aufweist, kann die Verspannung der Quantenschicht mittels der Verspannung der Barriereschicht kompensiert sein. Dies kann zu einer verbesserten Kristallqualität der Halbleiterschichtenfolge führen. Versetzungen, die sich in stark verspannten Quantenschicht vermehrt ausbilden, können so mit Vorteil vermindert werden.

Die intrinsische Gitterkonstante von Halbleitern hängt in der Regel von der Materialzusammensetzung des Halbleiters ab. Bei hinreichend dünnen Halbleiterschichten kann die Gitterkonstante der Halbleiterschicht von der entsprechenden intrinsischen Gitterkonstante des Halbmaterials abweichen.

Eine Halbleiterschicht wird im Rahmen der Erfindung insbesondere als verspannt angesehen, wenn bei der, beispielsweise epitaktischen, Abscheidung auf einer Referenzschicht eine Halbleiterschicht mit einer Gitterkonstante entsteht, die in lateraler Richtung, das heißt in einer Richtung senkrecht zur Richtung der Abscheidung, von der intrinsischen Gitterkonstante der Halbleiterschicht verschieden ist. Dabei ist die Gitterkonstante der verspannten Halbleiterschicht in lateraler Richtung gleich derjenigen der Referenzschicht.

Die Referenzschicht kann insbesondere ein Aufwachssubstrat, auf dem die Abscheidung der Halbleiterschicht erfolgt ist, oder eine Halbleiter-Pufferschicht, deren Gitterkonstante von der intrinsischen Gitterkonstante der Halbleiter-Pufferschicht nicht oder nicht wesentlich abweicht, sein.

Verspannte Halbleiterschichten, die wie oben beschrieben in lateraler Richtung die Gitterkonstante der Referenzschicht aufweisen und bei denen die Verspannung nicht oder nur zu einem geringen Teil in Form von Versetzungen abgebaut wird, werden auch als pseudomorph bezeichnet.

Halbleiterschichten, deren Gitterkonstante kleiner ist als ihre intrinsische Gitterkonstante, werden als druckverspannt oder positiv verspannt bezeichnet.

Analog dazu werden Halbleiterschichten, deren Gitterkonstante größer ist als ihre intrinsische Gitterkonstante, als zugverspannt oder negativ verspannt bezeichnet.

Eine druckverspannte, also positiv verspannte, und eine zugverspannte, also negativ verspannte, Halbleiterschicht weisen somit eine Verspannung mit zueinander entgegengesetztem Vorzeichen auf.

Die akkumulierte Verspannung einer Halbleiterschicht kann durch eine darüber oder darunter liegende Halbleiterschicht mit einer Verspannung mit entgegengesetztem Vorzeichen teilweise oder vollständig kompensiert werden, was auch als Verspannungskompensation bezeichnet wird. Ein Maß für die Verspannung von n aufeinander angeordneten verspannten Halbleiterschichten ist die so genannte mittlere Verspannung $V_0$, welche gegeben ist durch

$$V_O = \frac{\sum\limits_{l=1}^{n} f_l d_l}{\sum\limits_{l=1}^{n} d_l},$$

wobei $f_1$ die Verspannung der 1-ten Halbleiterschicht und $d_1$ die Dicke der 1-ten Halbleiterschicht ist. Das Produkt $f_1 \cdot d_1$ ist das Produkt von Verspannung und Schichtdicke der 1-ten Halbleiterschicht. Dabei ist die Verspannung $f_1$ gegeben durch

$$f_l = \frac{g_l - g_0}{g_0},$$

wobei $g_1$ die intrinsische Gitterkonstante der 1-ten Halbleiterschicht und $g_0$ die Gitterkonstante der Referenzschicht und damit die tatsächliche Gitterkonstante der verspannten Halbleiterschicht ist.

Bei geeigneter Wahl der.Schichtdicken und der Verspannung kann sich die mittlere Verspannung der verspannten Halbleiterschichten teilweise oder vollständig, also vereinfacht zu einem Wert von 0, kompensieren.

Mittels dieser Verspannungskompensation ist es möglich, vergleichsweise dicke. Halbleiterschichtstapel mit hoher Kristallqualität abzuscheiden. Kristalldefekte wie Versetzungen, die in stark verspannten Schichten vermehrt auftreten, können so vorteilhaft vermindert werden.

In einer bevorzugten Ausgestaltung weist die Quantenstruktur zumindest eine weitere Quantenschicht und zumindest eine weitere Barriereschicht auf, wobei die weitere Quantenschicht und die weitere Barriereschicht mit zueinander entgegengesetzten Vorzeichen verspannt sind.

Bevorzugt weist der LED-Halbleiterkörper vier Quantenschichten oder mehr, besonders bevorzugt zehn Quantenschichten oder mehr, beispielsweise fünfzehn Quantenschichten, auf.

Eine derart hohe Anzahl von Quantenschichten hat den Vorteil, dass sich der LED-Halbleiterkörper im Betrieb durch eine verbesserte Linearität bei hohen Strömen, insbesondere bei Strömen von oberhalb von 0,5 A, auszeichnen kann. Dies bedeutet, dass die Strahlungsleistung der im LED-Halbleiterkörper erzeugten Strahlung auch bei-hohen Strömen bei einer Erhöhung des Betriebsstroms linear mit dem Betriebsstrom ansteigt. Je höher die Anzahl der Quantenschichten ist, desto höher ist der Wert des Betriebsstroms, bis zu dem die Strahlungsleistung der im LED-Halbleiterkörper erzeugten Strahlung linear mit dem Betriebsstrom zunimmt.

In einer bevorzugten Ausgestaltung ist.die Quantenstruktur zur Erzeugung von Strahlung mit einer Peak-Wellenlänge im Wellenlängenbereich von einschließlich 750 nm bis einschließlich 1050 nm vorgesehen. Dieser Spektralbereich, insbesondere dessen Anteil außerhalb der Empfindlichkeit des menschlichen Auges, ist beispielsweise vorteilhaft für Sensorsysteme mit Sender und Empfänger, da das menschliche Auge von einer Strahlung des Senders nicht gestört wird.

In einer vorteilhaften Weiterbildung ist die Quantenstruktur derart ausgebildet, dass die Halbwertsbreite des Emissionsspektrums von der Quantenstruktur erzeugten Strahlung 70 nm oder weniger, bevorzugt 60 nm oder weniger, besonders bevorzugt 50 nm oder weniger, beispielsweise zwischen einschließlich 40 und einschließlich 45 nm, beträgt. Hierbei wird unter der Halbwertsbreite die volle spektrale Breite der emittierten Strahlung bei auf das Maximum bezogen halber Strahlungsleistung (FWHM, full width at half maximum) verstanden.

Mit schmalbandig emittierenden LEDs als Sender können vereinfacht Sensörsysteme mit Sender und Empfänger realisiert werden. Weiterhin ist ein Emissionsspektrum mit einer möglichst geringen spektralen Breite im Nahen Infrarot vorteilhaft, da spektrale Ausläufer des Spektrums in den sichtbaren Spektralbereich vermindert werden können. Eine Blendung des menschlichen Auges kann so vereinfacht vermieden werden.

In einer bevorzugten Ausgestaltung ist zumindest eine Quantenschicht druckverspannt und eine Barriereschicht zugverspannt. Mittels der zugverspannten Barriereschicht kann die Druckverspannung der Quantenschicht vollständig oder zumindest teilweise kompensiert werden. Eine vollständige Kompensation der Verspannung erfolgt, wenn das Produkt von Verspannung und Schichtdicke der Quantenschicht betragsmäßig gleich dem Produkt von Verspannung und Schichtdicke der Barriereschicht ist, wobei diese Produkte unterschiedliche Vorzeichen aufweisen. Dadurch kann vorteilhaft eine hohe Kristallqualität des LED-Halbleiterkörpers erzielt werden. Das Ausbilden von Kristallfehlern wie Versetzungen kann vermindert werden.

Insbesondere ermöglicht die Verspannungskompensation die Herstellung einer Halbleiterschichtenfolge, bei der die Summe der Dicken der Quantenschichten oberhalb der kritischen Schichtdicke für eine Quantenschicht liegt. Die kritische Schichtdicke einer Halbleiterschicht ist dabei eine materialspezifische Obergrenze für pseudomorphes Wachstum der Halbleiterschicht. Oberhalb der kritischen Schichtdicke ist ein die Kristallqualität mindernder Abbau der Verspannung in Form von Versetzungen typisch. Gegenüber einer Halbleiterschichtenfolge, in der die Verspannung der Quantenschicht nicht kompensiert ist, ermöglicht die Verspannungskompensation eine Erhöhung der Anzahl der Quantenschichten.

In einer weiteren bevorzugten Ausgestaltung ist die Verspannung von zumindest einer Barriereschicht betragsmäßig kleiner als eine Verspannung der Quantenschicht. Bevorzugt liegt der Betrag der Verspannung der Barriereschicht zwischen einem Wert von einschließlich 0,2 und einschließlich 0,67, besonders bevorzugt zwischen einschließlich 0,33 und einschließlich 0,5, des Betrags der Verspannung der Quantenschicht. Hierbei ist die Barriereschicht zur Kompensation der Verspannung der Quantenschicht bevorzugt entsprechend dicker als die Quantenschicht.

In einer bevorzugten Weiterbildung ist das Verhältnis der Dicke der Barriereschicht zu der Dicke der Quantenschicht größer oder gleich 1 bevorzugt größer oder gleich 1, 5, besonders bevorzugt größer oder gleich 2,5, beispielsweise bis zu 3.

Bei Quantenstrukturen, bei denen die Dicke der zwischen zwei benachbarten Quantenschichten angeordneten Barriereschicht größer ist als die Einzeldicken der Quantenschichten, können die sich in den Quantenschichten ausbildenden quantisierten Zustände der.Ladungsträger vereinfacht von den Zuständen der benachbarten Quantenschicht entkoppelt sein. Durch diese Entkopplung wird die Erzeugung einer spektral schmalbandigen Strahlung mittels der Quantenstruktur erleichtert.

In einer bevorzugten Weiterbildung beträgt die Dicke der Barriereschicht 5 nm oder mehr, bevorzugt 10 nm oder mehr, besonders bevorzugt 20 nm oder mehr.

Mit zunehmender Dicke der Barriereschicht können zwei Quantenschichten, die mittels der Barriereschicht voneinander getrennt sind, besonders gut voneinander entkoppelt werden.

In einer bevorzugten Ausgestaltung sind die Quantenschichten und die Barriereschichten in der Quantenstruktur in alternierender Abfolge aufeinander angeordnet. Dabei sind die Barriereschichten bevorzugt jeweils so ausgebildet, dass das Produkt von Verspannung und Schichtdicke einer Quantenschicht jeweils durch das Produkt von Verspannung und Schichtdicke der nachfolgenden Barriereschicht vollständig oder im Wesentlichen vollständig kompensiert wird. Dies kann zu einer Reduktion der mittleren Verspannung der Quantenstruktur führen. Mit Vorteil kann so eine gegenüber einer nicht verspannungskompensierten Halbleiterschichtenfolge vergleichsweise dicke Quantenstruktur mit hoher Kristallqualität ausgebildet sein.

Insbesondere kann die Zahl der in der Quantenstruktur entstehenden Versetzungen verringert werden. Dadurch kann sich die Zahl der Ladungsträger, die in der Quantenstruktur an solchen Versetzungen nichtstrahlend rekombinieren, reduziert werden. Dies kann vorteilhafterweise eine gesteigerte interne Quanteneffizienz im Betrieb des Halbleiterkörpers zur Folge haben.

In einer bevorzugten Ausgestaltung enthält der LED-Halbleiterkörper ein III-V Halbleitermaterial, beispielsweise $In_yGa_{1-y}As$ mit $0 \leq y \leq 1$, bevorzugt mit $y \neq 0$. Bevorzugt enthält zumindest eine Quantenschicht $In_yGa_{1-y}As$ mit $0 \leq y \leq 0,5$, bevorzugt mit $0,05 \leq y \leq 0,3$, besonders bevorzugt mit $0,1 \leq y \leq 0,2$. Bei $In_yGa_{1-y}As$ nimmt die intrinsische Gitterkonstante mit zunehmendem Indium-Gehalt zu. Damit steigt die Druckverspannung einer $In_yGa_{1-y}As$-Halbleiterschicht bezogen auf GaAs ebenfalls mit zunehmendem. Indium-Gehalt an. Eine druckverspannte $In_yGa_{1-y}As$-Halbleiterschicht weist dabei in Abscheiderichtung eine größere Gitterkonstante auf als in lateraler Richtung.

Ein LED-Halbleiterkörper mit einer $In_yGa_{1-y}As$-haltigen Quantenschicht kann sich insbesondere im Wellenlängenbereich von einschließlich 750 nm bis einschließlich 1050 nm durch eine hohe Quanteneffizienz auszeichnen.

Die Barriereschicht kann beispielsweise $Al_xGa_{1-x}As_{1-z}P_z$ mit $0 \leq x \leq 1$ und $0 \leq z \leq 1$, bevorzugt mit $z \neq 0$, enthalten. Die intrinsische Gitterkonstante einer derartigen Halbleiterschicht nimmt mit zunehmendem Phosphor-Gehalt ab, wobei bei einer zugverspannten $Al_xGa_{1-x}As_{1-z}P_z$-Halbleiterschicht die Gitterkonstante in Abscheiderichtung kleiner ist als die Gitterkonstante in lateraler Richtung.. Bezogen auf GaAs nimmt die Zugverspannung mit zunehmendem Phosphor-Gehalt zu, so dass über die Variation des Phosphor-Gehalts die Verspannung einer druckverspannten $In_yGa_{1-y}As$-haltigen Halbleiterschicht mittels einer $Al_xGa_{1-x}As_{1-z}P_z$-Halbleiterschicht kompensiert werden kann. Weiterhin kann die Bandlücke einer $Al_xGa_{1-x}As_{1-z}P_z$-Halbleiterschicht über den Aluminium-Gehalt eingestellt werden. Bei einem Quantentopf, der mittels einer $In_yGa_{1-y}As$-Quantenschicht und zweier $Al_xGa_{1-x}As_{1-z}P_z$-Barriereschichten gebildet ist, ermöglicht eine Variation des Aluminium-Gehalts ein vereinfachtes Einstellen der energetischen Tiefe des Quantentopfs.

Als Aufwachssubstrat für eine, beispielsweise epitaktische Abscheidung der Halbleiterschichten, etwa mittels MBE oder MOVPE, kann ein GaAs-Substrat eingesetzt werden.

Selbstverständlich können bei einem LED-Halbleiterkörper, der eine Mehrzahl von Quantenschichten und eine Mehrzahl von Barriereschichten aufweist, auch mehrere Quantenschichten und/oder Barriereschichten oder alle Quantenschichten und/oder Barriereschichten die in den angegebenen bevorzugten Ausgestaltungen angeführten Merkmale aufweisen.

In einer bevorzugten Ausgestaltung ist die Quantenstruktur zwischen zwei Mantelschichten eingebettet, wobei eine der Mantelschichten die Referenzschicht bilden kann. Besonders bevorzugt ist die eine Mantelschicht p-dotiert und die andere Mantelschicht n-dotiert ausgebildet. So kann der LED-Halbleiterkörper in Form einer PIN-Diodenstruktur ausgebildet sein, wobei die Quantenstruktur bevorzugt intrinsisch ausgeführt ist.

Zumindest eine Mantelschicht weist bevorzugt eine Bandlücke auf, welche größer ist als die Bandlücke einer Barriereschicht. Für die sich in der Quantenstruktur befindlichen Ladungsträger kann die Mantelschicht somit eine Potentialbarriere darstellen. Diese kann Ladungsträger daran hindern, aus der Quantenstruktur in die Mantelschicht zu gelangen..Eine strahlende Rekombination der Ladungsträger innerhalb der Quantenstruktur wird so gefördert.

In einer weiteren bevorzugten Ausgestaltung beträgt die mittlere Verspannung der Quantenstruktur 2000 ppm (parts per million) oder weniger, bevorzugt 1000 ppm oder weniger, besonders bevorzugt 500 ppm oder weniger. Je niedriger die mittlere Verspannung der Quantenstruktur ist, desto höher kann die Kristallqualität der Quantenstruktur sein.

Der LED-Halbleiterkörper ist als Dünnfilm-Halbleiterkörper ausgeführt. Bei einem Dünnfilm-Halbleiterkörper ist im Gegensatz zu einem herkömmlichen Halbleiterkörper das Aufwachssubstrat, auf dem die Halbleiterschichtenfolge des Halbleiterkörpers, beispielsweise epitaktisch, abgeschieden ist, vollständig oder bereichsweise gedünnt oder vollständig oder bereichsweise entfernt. Dies kann beispielsweise mechanisch und/oder chemisch erfolgen. Auch ein Lasertrennverfahren oder das Verfahren der Laserablation ist hierfür geeignet.

Ein Dünnfilm-Halbleiterchip kann den Dünnfilm-Halbleiterkörper und einen Träger umfassen, wobei der Halbleiterkörper auf dem Träger angeordnet und vorzugsweise befestigt ist. Der Träger ist insbesondere vom Aufwachssubstrat des Halbleiterkörpers verschieden. Der Träger kann der mechanischen Stabilisierung des Halbleiterkörpers dienen. Da Aufwachssubstrat ist hierfür nicht mehr erforderlich und kann ohne eine wesentliche Gefahr der Schädigung des Halbleiterkörpers gedünnt oder entfernt werden.

Mit Vorteil muss der Träger im Gegensatz zu dem Aufwachssubstrat nicht die hohen Anforderungen hinsichtlich kristalliner Reinheit erfüllen, sondern kann vielmehr im Hinblick auf andere Kriterien, wie beispielsweise mechanische Stabilität, optische, thermische oder elektrische Eigenschaften ausgewählt werden.

Ein Dünnfilm-Halbleiterchip, etwa ein Dünnfilm-LED-Chip, kann sich weiterhin durch mindestens eines der folgenden charakteristischen Merkmale auszeichnen:

- an einer zu einem Trägerelement hin gewandten ersten Hauptfläche einer Halbleiterschichtenfolge, die eine aktive Zone umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von $20\,\mu$m oder weniger, insbesondere im Bereich von $10\,\mu$m auf ; und/ oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

In einer bevorzugten Ausgestaltung ist auf dem Halbleiterköper eine Spiegelschicht angeordnet. Besonders bevorzugt ist die Spiegelschicht zwischen dem Träger und dem Halbleiterkörper angeordnet. Dabei ist die Spiegelschicht für im Betrieb des Halbleiterkörpers erzeugte Strahlung reflektierend ausgebildet. Die Spiegelschicht ist weiterhin bevorzugt metallisch ausgeführt. Beispielsweise kann die metallische Spiegelschicht Au, Ag, Al, Pt oder eine Legierung mit mindestens einem dieser Materialien enthalten. Au zum Beispiel zeichnet sich durch eine besonders hohe Reflektivität im roten und infraroten Spektralbereich aus.

In der Quantenstruktur erzeugte und in Richtung des Trägers verlaufende Strahlung kann an der Spiegelschicht reflektiert und an einer der Spiegelschicht abgewandten, eine Strahlungsaustrittsfläche bildenden, Oberfläche des Halbleiterchips aus diesem ausgekoppelt werden. Der durch die Strahlungsaustrittsfläche ausgekoppelte Strahlungsanteil wird dementsprechend mit Vorteil erhöht. Weiterhin kann die Spiegelschicht einer Absorption von Strahlung durch das Trägermaterial vorbeugen. Die Freiheitsgrade bei der Auswahl des Trägermaterials sind so weitergehend erhöht.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:

Figur 1 eine schematische Schnittansicht eines LED-Halbleiterchips mit einem erfindungsgemäßen LED-Halbleiterkörper, und
Figur 2 eine graphische Darstellung des Verlaufs der Bandlücke und der Materialzusammensetzungen für ein Ausführungsbeispiel eines erfindungsgemäßen LED-Halbleiterkörpers in einem Ausschnitt um eine Quantenstruktur des LED-Halbleiterkörpers.

Gleiche, gleichartige und gleich wirkende Elemente sind in den Figuren mit den gleichen Bezugszeichen versehen.

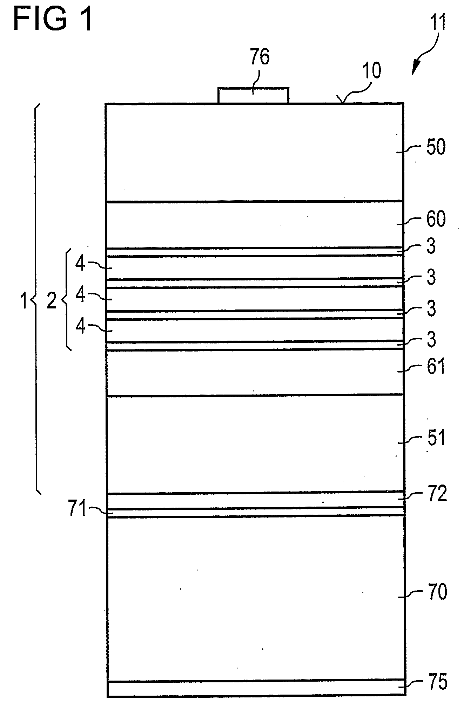

In Figur 1 ist in einer schematischen Schnittansicht der Aufbau eines LED-Halbleiterchips 11 mit einem erfindungsgemäßen Halbleiterköper 1 dargestellt. Der LED-Halbleiterkörper 1 ist durch eine Halbleiterschichtenfolge gebildet, die eine Quantenstruktur 2 umfasst. Diese Quantenstruktur weist beispielhaft vier Quantenschichten 3 auf, wobei zwischen jeweils zwei benachbarten Quantenschichten jeweils eine Barriereschicht 4 angeordnet ist. Bei einer Anzahl von n Quantenschichten beträgt die Anzahl der Barriereschichten in der Regel n-1. Vom in Figur 1 gezeigten Ausführungsbeispiel abweichend kann die Anzahl der Barriereschichten aber auch n+1 betragen.

Die Quantenstruktur 2 ist zwischen einer ersten Mantelschicht 50 und einer zweiten Mantelschicht 51 angeordnet. Eine Strahlungsauskoppelfläche 10 ist mittels einer Oberfläche der ersten Mantelschicht 50 gebildet.

Der LED-Halbleiterchip 11 ist als Dünnfilm-Halbleiterchip ausgeführt. Dabei ist der LED-Halbleiterkörper 1 auf einem Träger 70 des LED-Halbleiterchips 11 angeordnet. Dieser Träger ist von einem Aufwachssubstrat für den Halbleiterkörper 1, insbesondere die Halbleiterschichtenfolge, verschieden. Die Abscheidung der Halbleiterschichtenfolge auf dem Aufwachssubstrat bei der Herstellung des Halbleiterkörpers erfolgt vorzugsweise epitaktisch, beispielsweise mittels MBE oder MOVPE. Der Träger muss demnach hinsichtlich der kristallinen Reinheit nicht den hohen Anforderungen an ein Aufwachssubstrat genügen, sondern kann beispielsweise hinsichtlich der Wärmeableitungseigenschaften und/oder der elektrischen Leitfähigkeit optimiert ausgeführt sein. Ein Dünnfilm-Halbleiterchip, bei dem das Aufwachssubstrat für den Halbleiterkörper während der Herstellung abgelöst ist, ist deshalb für Hochleistungs-LED-Halbleiterchips mit vergleichsweise hoher im Halbleiterchip entstehender Verlustwärme besonders geeignet.

Weiterhin dient der Träger der mechanischen Stabilisierung der Halbleiterschichtenfolge nach dem Entfernen des Aufwachssubstrats. Das Entfernen des Aufwachssubstrats kann dabei beispielsweise mechanisch und/oder chemisch vollständig oder bereichsweise entfernt oder gedünnt sein. Auch ein Lasertrennverfahren oder das Verfahren der Laserablation kann hierfür Anwendung finden. Vorzugsweise ist das Aufwachssubstrat vollständig entfernt. In der Figur 1 ist das Aufwachssubstrat deshalb nicht dargestellt.

Bevorzugt weist der Träger eine vergleichsweise hohe Wärmeleitfähigkeit auf. Beispielsweise kann der Träger. Germanium enthalten oder aus Germanium bestehen. Auch ein GaAs-Träger kann Anwendung finden. Enthält der Träger ein Halbleitermaterial oder besteht der Träger aus einem Halbleitermaterial, so ist dieser mit Vorzug zur Erhöhung der elektrischen Leitfähigkeit geeignet dotiert.

Zwischen dem Halbleiterkörper 1 und dem Träger 70 ist eine Spiegelschicht 72 angeordnet, die vorzugsweise auf dem Halbleiterkörper aufgebracht ist. In der Quantenstruktur im Betrieb des LED-Halbleiterkörpers erzeugte und in Richtung des Trägers 70 abgestrahlte Strahlung kann von der Spiegelschicht reflektiert werden. Hierdurch wird eine Absorption in der der Spiegelschicht von der Quantenstruktur aus gesehen nachgeordneten Strukturen, etwa dem Träger, vermieden. Die Spiegelschicht kann ein Metall oder eine metallische Legierung enthalten oder metallisch ausgeführt sein. Beispielsweise kann die Spiegelschicht Gold, Silber, Aluminium, Platin oder eine Legierung mit mindestens einem dieser Materialien enthalten oder aus einem solchen Material oder einer solchen Legierung bestehen. Gold beispielsweise zeichnet sich im gelben, orangen, roten bis in den infraroten Spektralbereich durch besonders hohe Reflektivitäten aus. Im Vergleich zu einem Bragg-Spiegel, der in den Halbleiterkörper integriert sein kann, kann sich die Spiegelschicht auf Metallbasis oder auf metallischer Legierungsbasis durch eine hohe Reflektivität in einem vergleichsweise breiten Spektralbereich auszeichnen. Auch die Abhängigkeit der Reflektivität von dem Winkel, in dem die Strahlung auf die Spiegelschicht auftrifft, kann bei einer Spiegelschicht auf Metallbasis oder auf metallhaltiger Legierungsbasis im Vergleich zu einem.Bragg-Spiegel vorteilhaft reduziert sein. Eine als Metallschicht oder Legierungsschicht ausgeführte Spiegelschicht ist deshalb gegenüber einem Bragg-Spiegel bevorzugt. In der Quantenstruktur 2 erzeugte und auf die Spiegelschicht auftreffende Strahlung kann so effizient von der Spiegelschicht reflektiert werden. In der Folge kann die aus der Strahlungsauskoppelfläche 10 austretende Strahlungsleistung vorteilhaft gesteigert werden.

Bei der Herstellung des LED-Halbleiterchips 11 erfolgt die Abscheidung des Metalls oder die Ausbildung der Legierung der Spiegelschicht auf dem vorgefertigten Halbleiterkörper 1, insbesondere nach Abschluss der Abscheidung des Halbleiterkörpers. Geeignete Verfahren für die Herstellung der Spiegelschicht 72 sind beispielsweise Sputtern oder Aufdampfen.

Weiterhin ist zwischen der Spiegelschicht 72 und dem Träger 70 eine Verbindungsschicht 71 ausgebildet. Diese Verbindungsschicht dient der Befestigung des Halbleiterkörpers 1 an dem Träger. Die Verbindungsschicht ist bevorzugt elektrisch leitfähig ausgebildet und kann beispielsweise als Lotschicht ausgeführt sein.

Weiterhin ist auf der dem LED-Halbleiterchip abgewandten Seite des Trägers 70 ein Kontakt 75 angeordnet. Mittels dieses Kontakts sowie dem auf der Strahlungsaustrittsfläche 10 angeordneten Kontakt 76 ist der LED-Halbleiterkörper 1 elektrisch anschließbar. Im Betrieb des LED-Halbleiterkörpers können so mittels dieser Kontakte Ladungsträger in die zur Erzeugung von Strahlung vorgesehene Quantenstruktur 2 injiziert werden. Der Kontakt 75 und/oder der' Kontakt 76 ist bevorzugt metallisch oder als metallische Legierung ausgeführt. Beispielsweise kann der Kontakt eines der Materialen Au, Ni, Ti, Pt, Al, Ag oder eine Legierung mit zumindest einem dieser Materialien enthalten oder daraus bestehen. Selbstverständlich kann der Kontakt 75 und/oder der Kontakt 76 gegebenenfalls auch mehrschichtig ausgebildet sein.

Alternativ oder ergänzend kann der Kontakt zumindest ein strahlungsdurchlässiges elektrisch leitfähiges Metalloxid (TCO, Transparent Conductive Oxide)-Material, beispielsweise ITO (Indium Tin Oxide), enthalten oder daraus bestehen.

Die Herstellung der Kontakte 75 und 76 kann beispielsweise mittels Sputterns oder Aufdampfens, vorzugsweise auf dem vorgefertigten Halbleiterkörper 1, erfolgen.

Der LED-Halbleiterkörper kann beispielsweise als PIN-Diodenstruktur ausgeführt sein. Dabei kann beispielsweise die erste Mantelschicht 50 p-leitend dotiert und die zweite Mantelschicht 51 n-leitend dotiert sein, oder umgekehrt. Die Halbleiterschichten der Quantenstruktur 2, die-zwischen der Quantenstruktur und der ersten Mantelschicht 50 vorzugsweise angeordnete Zwischenschicht sowie die zwischen der Quantenstruktur und der zweiten Mantelschicht vorzugsweise angeordnete Zwischenschicht 61 sind bevorzugt undotiert ausgebildet. Im Betrieb des LED-Halbleiterchips führt die Rekombination von in die Quantenstruktur injizierten Ladungsträgern zur spontanen Emission von inkohärenter Strahlung. Hierbei erfolgt die strahlende Rekombination der Ladungsträger bevorzugt in den Quantenschichten.

Eine Quantenschicht 3 und eine Barriereschicht 4 sind zueinander mit entgegengesetzten Vorzeichen verspannt. Beispielsweise kann die Quantenschicht druckverspannt, also positiv verspannt, und die Barriereschicht zugverspannt, also negativ verspannt, sein. In einem LED-Halbleiterkörper 1 mit einer verspannten Quantenschicht 3 kann die Diffusion von Kristallfehlern, zum Beispiel Versetzungen, vermindert sein. Eine Degradation des LED-Halbleiterkörpers und eine damit verbundene Abnahme der vom Halbleiterkörper abgestrahlten Strahlungsleistung mit zunehmender Betriebsdauer kann vorteilhaft reduziert sein. Ein LED-Halbleiterkörper mit einer verspannten Quantenschicht kann sich also durch ein verbessertes Lichtalterungsverhalten auszeichnen.

Durch die Verspannung der Barriereschicht 4 mit einem zur Verspannung der Quantenschicht 3 entgegengesetzten Vorzeichen kann die mittlere Verspannung der Halbleiterschichtenfolge vermindert sein. Dabei ist die Barriereschicht bevorzugt so ausgeführt, dass das Produkt von Verspannung und Schichtdicke für die Barriereschicht und für die Quantenschicht betragsmäßig jeweils den gleichen oder im wesentlichen gleichen Wert aufweist. Eine hohe Kristallqualität der Halbleiterkörpers 1, insbesondere der Quantenstruktur 2, ist so vereinfacht erzielbar. Ein die Kristallqualität mindernder Abbau der Verspannung der verspannten Halbleiterschichten in Form von Kristalldefekten wie beispielsweise Versetzungen wird vorteilhaft verringert. Der Anteil von Ladungsträgern in der Quantenstruktur 2, der an solchen Kristalldefekten nicht-strahlend rekombiniert, kann sich bei einer Abnahme der Dichte von Kristalldefekten verringern, was eine Steigerung der strahlenden Rekombination in der Quantenstruktur und somit eine Erhöhung der internen Quanteneffizienz des LED-Halbleiterkörpers zur Folge hat.

Durch die Kompensation der Verspannung der Quantenschichten 3 mittels der Barriereschichten 4 ist eine vergleichsweise große Anzahl von Quantenschichten 3 und Barriereschichten 4 mit guter Kristallqualität herstellbar. Dabei sind die verspannten Quantenschichten und Barriereschichten vorzugsweise in alternierender Abfolge aufeinander angeordnet.

Die Quantenstruktur 2 kann mehr als vier Quantenschichten 3, bevorzugt zehn Quantenschichten oder mehr, beispielsweise 15 Quantenschichten oder mehr, enthalten. Mit zunehmender Anzahl der Quantenschichten kann die Linearität des Bauteils bezüglich des Betriebsstroms, insbesondere bei hohen Strömen oberhalb von 0,5 A noch weiter gesteigert werden.

Weiterhin kann eine Erhöhung der Anzahl der Quantenschichten zu einer Reduzierung der spektralen Breite führen.

Insbesondere ist der LED-Halbleiterkörper vorzugsweise derart ausgeführt, dass das Spektrum der von der Quantenstruktur erzeugten Strahlung eine Halbwertsbreite von 70 nm oder weniger, bevorzugt 60 nm oder weniger, besonders bevorzugt 50 nm oder weniger, beispielsweise 40 bis 45 nm beträgt.

Der Betrag der Verspannung einer Barriereschicht 4 weist bevorzugt einen Wert zwischen einschließlich 0,2 und einschließlich 0,67, besonders bevorzugt zwischen einschließlich 0,33 und einschließlich 1/2 des Betrags der Verspannung einer angrenzenden Quantenschicht 3 auf. Bei einer derartigen Barriereschicht kann die Dicke der Barriereschicht zur Kompensation der Verspannung der zugehörigen Quantenschicht entsprechend dicker als die Quantenschicht gewählt werden. Zwei benachbarte Quantenschichten 3, zwischen denen die Barriereschicht 4 angeordnet ist, können also vergleichsweise weit voneinander beabstandet sein. Die sich in einer Quantenschicht ausbildenden energetischen Zustände können so vorteilhaft von denen der benachbarten Quantenschicht entkoppelt sein. Ein LED-Halbleiterkörper mit einer spektral vergleichsweise schmalbandigen Emission ist so vereinfacht herstellbar.

Ein Verhältnis der Dicke der Barriereschicht 4 zur Dicke der Quantenschicht 3 von größer oder gleich 1, bevorzugt größer oder gleich 1,5, besonders bevorzugt größer oder gleich 2,5, beispielsweise 3, hat sich als besonders vorteilhaft erwiesen. Die Dicke der Barriereschicht kann 5 nm oder mehr, bevorzugt 10 nm oder mehr, besonders bevorzugt 20 nm oder mehr, betragen. Die Dicke der Quantenschichten beträgt dabei typischerweise zwischen einschließlich 3 und einschließlich 10 nm, beispielsweise 5 nm.

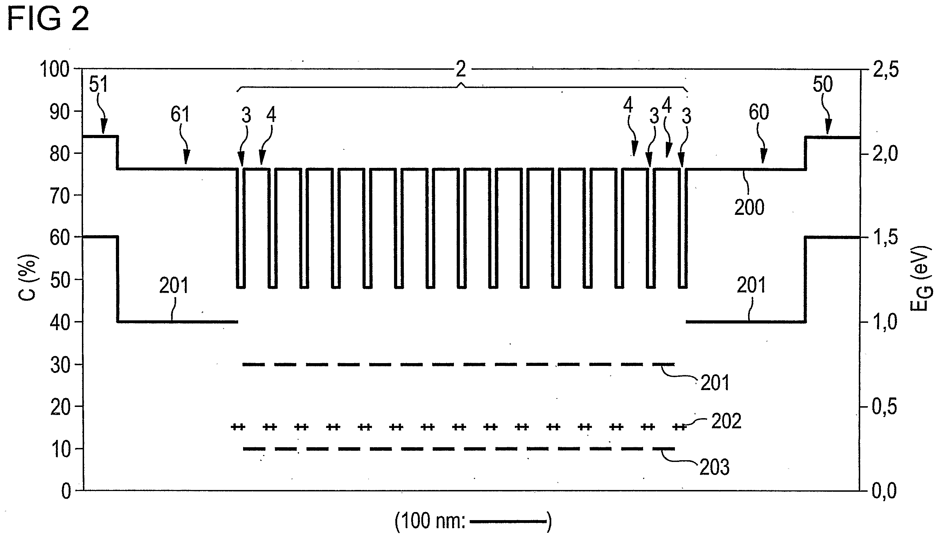

In Figur 2 zeigt die Kurve 200 den Verlauf der Bandlücke EG für ein Ausführungsbeispiel eines erfindungsgemäßen LED-Halbleiterkörpers in einem Ausschnitt um die Quantenstruktur 2. Dabei ist auch der Bereich der Zwischenschichten 60 und 61 sowie ein Teil der an die an die erste Zwischenschicht 60 angrenzenden ersten Mantelschicht 50 und ein Teil der an die zweite Zwischenschicht 61 angrenzenden zweiten Mantelschicht 51 gezeigt. Der Verlauf der Bandlücke $E_G$ ist lediglich beispielhaft für einen Halbleiterkörper gezeigt, der für die Emission von Strahlung mit einer Peak-Wellenlänge von 940 nm ausgebildet ist.

In dem. in Figur 2 gezeigten Ausführungsbeispiel umfasst die Quantenstruktur 2 fünfzehn Quantenschichten 3, wobei jeweils zwischen 2 benachbarten Quantenschichten 3 jeweils eine Barriereschicht 4 angeordnet ist. Die Quantenschichten weisen jeweils eine Dicke von 7 nm und die Barriereschichten eine Dicke von 21 nm auf. Die Quantenschichten sind mittels $In_yGa_{1-y}As$ gebildet, wobei der Indium-Gehalt für eine Emissionswellenlänge von 940 nm 15% beträgt. Die Barriereschichten sind durch $Al_xGa_{1-x}As_{1-z}P_z$ gebildet, wobei der Aluminium-Gehalt 30% und der Phosphor-Gehalt 10% beträgt. In der Figur 2 ist der Verlauf des Aluminium-Gehalts durch die Kurve 201, der Verlauf des Indium-Gehalts durch die Kurve 202 und der Verlauf des Phosphor-Gehalts durch die Kurve 203 dargestellt.

Bei einem Indium-Gehalt von 15% beträgt die Verspannung von InGaAs gegenüber dem GaAs-Aufwachssubstrat etwa 10754 ppm. Dabei sind die InGaAs-Quantenschichten 3 druckverspannt gegenüber GaAs.

Die AlGaAsP-Barriereschichten 4 mit einem Aluminium-Gehalt von x = 30% und einem Phosphor-Gehalt von z = 10% sind mit einem Betrag der Verspannung von 3593 ppm gegenüber GaAs zugverspannt. Der Betrag der Verspannung der Barriereschichten beträgt somit etwa ein Drittel des Betrags der Verspannung der Quantenschichten 3. Entsprechend kann mittels einer Barriereschicht 4, die etwa dreimal so dick ist wie die Quantenschicht 3, die Verspannung dieser Quantenschicht durch die Verspannung dieser Barriereschicht kompensiert werden, da dann das Produkt von Verspannung und Schichtdicke für die Barriereschicht und.für die Quantenschicht einen betragsmäßig gleichen Wert mit zueinander entgegengesetzten Vorzeichen aufweisen kann. -

Typischerweise beträgt die mittlere Verspannung der Quantenstruktur insbesondere 2000 ppm oder weniger, bevorzugt 1000 ppm oder weniger, besonders bevorzugt 500 ppm oder weniger. So kann eine gute Kristallqualität der Quantenstruktur erreicht werden.

Selbstverständlich sind die angegebenen Materialzusammensetzungen als lediglich beispielhaft anzusehen. Durch Variation der Materialzusammensetzung und/oder der Schichtdicken kann von der Quantenstruktur 2 auch Strahlung mit einer größeren oder kleineren Peak-Wellenlänge, insbesondere im Wellenlängenbereich von einschließlich 750 nm bis einschließlich 1050 nm erzielt werden. Beispielsweise kann durch eine Erhöhung des Indium-Gehalts die Bandlücke verringert werden, was zu einer größeren Peak-Wellenlänge führen kann.

Auch eine Verbreiterung der Quantenschichten kann zu einer Verringerung der Übergangsenergie bei der Rekombination von einem Elektron mit.einem Loch und damit zur Emission von Strahlung mit einer größeren Peak-Wellenlänge führen, da sich die Grundzustandsenergie der Ladungsträger in den Quantenschichten bei Verbreiterung der Quantenschichten reduziert. Der Indium-Gehalt kann dabei wischen ausschließlich 0 und einschließlich 100%, bevorzugt zwischen einschließlich 5% und einschließlich 30%, besonders bevorzugt zwischen einschließlich 10% und einschließlich 20%, liegen. Da sich mit Zunahme des Indium-Gehalts nicht nur die Bandlücke von InGaAs verringert, sondern auch die Verspannung gegenüber GaAs zunimmt, ist es zweckmäßig, die Zusammensetzung der Barriereschichten 4 entsprechend an die Zusammensetzung Quantenschichten 3 anzupassen. Eine. Kompensation einer höheren Verspannung einer Quantenschicht kann dabei beispielsweise durch eine Erhöhung des Phosphor-Gehalts in einer Barriereschicht oder durch eine Verbreiterung der Barriereschicht erzielt werden.

Analog dazu kann bei einer Verringerung des Indium-Gehalts in einer Quantenschicht 3 die Emission von Strahlung mit einer größeren Peak-Wellenlänge erzielt werden. Aufgrund der mit abnehmendem Indium-Gehalt abnehmenden Verspannung der InGaAs-Quantenschichten, kann die Verspannung.der Quantenschichten durch dünnere Barriereschichten 4 oder durch. Barriereschichten mit verringertem Phosphorgehalt kompensiert werden.

Zur Kompensation der Verspannung von druckverspannten Quantenschichten 3, die mittels InGaAs gebildet sind, sind zugverspannte Barriereschichten 4, die AlGaAsP enthalten, besonders geeignet, da die Verspannung der Barriereschichten über den Phosphor-Gehalt auf einen für die Verspannungskompensation geeigneten Wert eingestellt werden kann.

Weiterhin kann die Bandlücke von AlGaAsP über den Aluminium-Gehalt eingestellt werden. Die Barriereschichten können hierbei eine gegenüber den Quantenschichten vergleichsweise hohe Bandlücke aufweisen. Dadurch kann mittels einer InGaAs-Quantenschicht, die zwischen zwei AlGaAsP-Barriereschichten mit entsprechend hohem Aluminium-Gehalt eingebettet ist, ein vergleichsweise energetisch tiefer Quantentopf gebildet sein. Je tiefer der Quantentopf ist, desto niedriger ist die Wahrscheinlichkeit, dass Ladungsträger in einem quantisierten Zustand der Quantenschicht infolge thermischer Anregung aus der Quantenschicht in die Barriereschicht gelangen. Die Wahrscheinlichkeit, dass Ladungsträger in der.Quantenschicht strahlend rekombinieren, kann in der Folge vorteilhaft erhöht sein, wodurch die.interne Quanteneffizienz der Quantenstruktur 2 zunimmt.

Die erste Zwischenschicht 60 und die zweite Zwischenschicht 61 weisen bevorzugt eine gleiche oder im wesentlichen gleiche Bandlücke auf wie die Barriereschicht 4. Im Unterschied zu den Barriereschichten 4 in der Quantenstruktur 2 sind die erste und die zweite Zwischenschichten jedoch bevorzugt nicht oder nicht wesentlich verspannt. In dem in Figur 2 gezeigten Ausführungsbeispiel sind die Zwischenschichten 60 und 61 als $Al_xGa_{1-x}As$-Halbleiterschichten ausgeführt und weisen einen gegenüber einem Aluminium-Gehalt von 30% in den. Barriereschichten 4 erhöhten Aluminium-Gehalt, beispielhaft einen Aluminium-Gehalt von 40%, auf. Durch die Ausführung der Zwischenschichten als AlGaAs-Halbleiterschichten sind diese bezogen auf GaAs vergleichsweise wenig verspannt. Eine zusätzliche Verspannung der Halbleiterschichtenfolge des Halbleiterkörpers 1 wird so vorteilhaft vermieden.

Der Aluminium-Gehalt der ersten Mantelschicht 50 und der zweiten Mantelschicht 51, die jeweils mittels AlGaAs gebildet sind., ist bevorzugt gegenüber dem Aluminium-Gehalt der Zwischenschichten 60 und 61 erhöht. So entsteht an den Übergängen von der ersten Zwischenschicht 60 zur ersten Mantelschicht 50 und von der zweiten Zwischenschicht 61 zur zweiten Mantelschicht 51 jeweils ein Potenzialsprung. Der Potenzialsprung ist zweckmäßigerweise so groß, dass eine thermische Anregung von Ladungsträgern aus der Zwischenschicht in die erste Mantelschicht 50 und die zweite Mantelschicht 51 mit einer hinreichend niedrigen Wahrscheinlichkeit erfolgt. Eine hinreichend niedrige Wahrscheinlichkeit wird erreicht, wenn die Differenz der Bandlücken an der Stelle des Potenzialsprungs erheblich, beispielsweise etwa fünfmal bis zehnmal, größer ist als die mittlere thermische Energie von Ladungsträgern bei Betriebstemperatur des Halbleiterkörpers. Bei dem in Figur 2. gezeigten Ausführungsbeispiel beträgt der Potenzialsprung etwa 200 meV, was in etwa der achtfachen mittleren thermischen Energie von Ladungsträgern bei Raumtemperatur entspricht. Der Anteil von in den Quantenschichten 3 der Quantenstruktur 2 unter Emission von Strahlung rekombinierenden Ladungsträgern kann so erhöht werden. Dies kann zu einer gesteigerten internen Quanteneffizienz des LED-Halbleiterchips führen.

Die Mantelschichten 50 and 51 sind bevorzugt vergleichsweise dick im Vergleich zu der Quantenstruktur ausgeführt. Beispielsweise beträgt die Dicke jeweils mindestens das zweifache der Dicke der Quantenstruktur 2. Die Mantelschichten dienen somit, insbesondere nach dem Ablösen des Aufwachssubstrats des Halbleiterkörpers 1, der mechanischen Stabilisierung der Quantenstruktur. Die Verspannung der Quantenschichten und der Barriereschichten muss nicht notwendigerweise auf das Aufwachssubstrat bezogen sein. Beispielsweise kann die Verspannung auch auf die im Vergleich zu der Quantenstruktur dicken Mantelschichten 50 oder 51 bezogen-sein. Die Verspannung der Quantenschichten 3 und Barriereschichten 4 der Quantenstruktur bleibt dadurch auch nach Ablösen des Substrats erhalten. Ein Abbau der Verspannung in Form von Versetzungen und eine damit einhergehende Verschlechterung der Kristallqualität der Quantenstruktur 2 nach Ablösen des Aufwachssubstrats kann so vorteilhafterweise vermieden werden.

Selbstverständlich können für den Halbleiterkörper 1 und für das Aufwachssubstrat auch andere Halbleitermaterialien, insbesondere III-V-Halbleitermaterialien Verwendung finden. Beispielsweise kann der Halbleiterkörper und insbesondere die Quantenstruktur 2 InAs, GaSb, AlSb, InP, AlAs, AlP oder GaP oder ein ternäres oder quaternäres Halbleitermaterial, das mittels dieser Halbleiter bildbar ist, enthalten.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

**Patentansprüche**

1. LED-(Light Emitting Diode)-Halbleiterkörper (1) mit einer Halbleiterschichtenfolge, die eine zur Erzeugung von inkohärenter Strahlung vorgesehene Quantenstruktur (2) mit mindestens einer Quantenschicht (3) und mindestens einer Barriereschicht (4) umfasst, wobei die Quantenschicht (3) und die Barriereschicht (4) mit zueinander entgegengesetzten Vorzeichen verspannt sind, **dadurch gekennzeichnet, dass** der LED-Halbleiterkörper (1) als Dünnfilm-Halbleiterkörper ausgeführt ist.

2. LED-Halbleiterkörper nach Anspruch 1, wobei die Quantenschicht (3) druckverspannt und die Barriereschicht (4) zugverspannt ist.

3. LED-Halbleiterkörper nach Anspruch 1 oder 2, wobei die Verspannung der Barriereschicht (4) betragsmäßig kleiner ist als die Verspannung der Quantenschicht (3).

4. LED-Halbleiterkörper nach Anspruch 3, wobei der Betrag der Verspannung der Barriereschicht (4) einen Wert zwischen einschließlich 0,2 und einschließlich 0,67 des Betrags der Verspannung der Quantenschicht (3) aufweist.

5. LED-Halbleiterkörper nach Anspruch 3, wobei der Betrag der Verspannung der Barriereschicht (4) einen Wert zwischen einschließlich 0,33 und einschließlich 1/2 des Betrags der Verspannung der Quantenschicht (3) aufweist.

6. LED-Halbleiterkörper nach mindestens einem der Ansprüche 1 bis 5, wobei das Verhältnis der Dicke der Barriereschicht (4) zu der Dicke der Quantenschicht (3) größer oder gleich 1, bevorzugt größer oder gleich 1,5, besonders bevorzugt größer oder gleich 2,5 ist.

7. LED-Halbleiterkörper nach mindestens einem der Ansprüche 1 bis 6, wobei die Quantenschicht (3) $In_yGa_{1-y}As$ mit $0 \le y \le 0,5$, bevorzugt mit $0,05 \le y \le 0,3$, besonders bevorzugt mit $0,1 \le y \le 0,2$, enthält.

8. LED-Halbleiterkörper nach mindestens einem der Ansprüche 1 bis 7, wobei die verspannte Barriereschicht (4) $Al_xGa_{1-x}As_{1-z}P_z$ mit $0,01 \le x \le 1$, bevorzugt mit $0,1 \le x \le 0,6$, besonders bevorzugt mit $0,2 \le x \le 0,4$ und/oder mit $0,01 \le z \le 0,5$, bevorzugt mit $0,03 \le z \le 0,3$, besonders bevorzugt mit $0,05 \le z \le 0,2$, enthält.

9. LED-Halbleiterkörper nach mindestens einem der Ansprüche 1 bis 8, wobei die Quantenstruktur (2) eine weitere Quantenschicht (3) und eine weitere Barriereschicht(4) aufweist und die weitere Quantenschicht (3) und die weitere Barriereschicht(4) mit ebenfalls zueinander entgegengesetztem Vorzeichen verspannt sind.

10. LED-Halbleiterkörper nach mindestens einem der Ansprüche 1 bis 9, wobei eine mittlere Verspannung der Quantenstruktur (2) 2000 ppm oder weniger, bevorzugt 1000 ppm oder weniger, besonders bevorzugt 500 ppm oder weniger beträgt.

11. LED-Halbleiterkörper nach mindestens einem der Ansprüche 1 bis 10, wobei der Halbleiterkörper (1) auf einem Träger (70) angeordnet ist, der von einem Aufwachssubstrat des Halbleiterkörpers (1) verschieden ist.

**12.** LED-Halbleiterkörper nach Anspruch 11, wobei zwischen dem Träger (70) und dem Halbleiterkörper (1) eine Spiegelschicht (72) angeordnet ist, wobei die Spiegelschicht (72) metallisch ausgeführt ist.

**13.** LED-Halbleiterkörper nach mindestens einem der Ansprüche 1 bis 12, wobei die Quantenstruktur (2) zur Erzeugung von Strahlung mit einer Peak-Wellenlänge im Wellenlängenbereich von einschließlich 750 nm bis einschließlich 1050 nm vorgesehen ist.

**14.** LED-Halbleiterkörper nach mindestens einem der Ansprüche 1 bis 13, wobei die Quantenstruktur derart ausgeführt ist, dass eine Halbwertsbreite des Spektrums der von der Quantenstruktur (2) erzeugten Strahlung 70 nm oder weniger, bevorzugt 60 nm oder weniger, besonders bevorzugt 50 nm oder weniger beträgt.

**15.** LED-Halbleiterkörper nach mindestens einem der Ansprüche 1 bis 14, wobei die Quantenstruktur (2) 4 Quantenschichten (3) oder mehr, bevorzugt 10 Quantenschichten oder mehr, aufweist.

**Claims**

**1.** LED (light emitting diode) semiconductor body (1) having a semiconductor layer sequence which comprises a quantum structure (2) which is intended to produce incoherent radiation and comprises at least one quantum layer (3) and at least one barrier layer (4), wherein the quantum layer (3) and the barrier layer (4) are strained with mutually opposite mathematical signs, **characterized in that** the LED semiconductor body (1) is in the form of a thin-film semiconductor body.

**2.** LED semiconductor body according to claim 1, wherein the quantum layer (3) is compressive-strained, and the barrier layer (4) is tensile-strained.

**3.** LED semiconductor body according to claim 1 or 2, wherein the absolute value of the strain of the barrier layer (4) is less than the strain of the quantum layer (3).

**4.** LED semiconductor body according to claim 3, wherein the absolute value of the strain of the barrier layer (4) has a value between 0.2 and 0.67 inclusive of the absolute value of the strain of the quantum layer (3).

**5.** LED semiconductor body according to claim 3, wherein the absolute value of the strain of the barrier layer (4) has a value between 0.33 and 1/2 inclusive of the absolute value of the strain of the quantum layer (3).

**6.** LED semiconductor body according to at least one of claims 1 to 5, wherein the ratio of the thickness of the barrier layer (4) to the thickness of the quantum layer (3) is greater than or equal to 1, preferably greater than or equal to 1.5, and particularly preferably greater than or equal to 2.5.

**7.** LED semiconductor body according to at least one of claims 1 to 6, wherein the quantum layer (3) contains $In_yGa_{1-y}As$ where $0 \leq y \leq 0.5$, preferably where $0.05 \leq y \leq 0.3$, and particularly preferably where $0.1 \leq y \leq 0.2$.

**8.** LED semiconductor body according to at least one of claims 1 to 7, wherein the strained barrier layer (4) contains $Al_xGa_{1-x}As_{1-z}P_z$ where $0.01 \leq x \leq 1$, preferably where $0.1 \leq x \leq 0.6$, and particularly preferably where $0.2 \leq x \leq 0.4$ and/or where $0.01 \leq z \leq 0.5$, preferably where $0.03 \leq z \leq 0.3$, particularly preferably where $0.05 \leq z \leq 0.2$.

**9.** LED semiconductor body according to at least one of claims 1 to 8, wherein the quantum structure (2) comprises a further quantum layer (3) and a further barrier layer (4), and the further quantum layer (3) and the further barrier layer (4) are strained with likewise mutually opposite mathematical signs.

**10.** LED semiconductor body according to at least one of claims 1 to 9, wherein a mean strain of the quantum structure (2) is 2000 ppm or less, preferably 1000 ppm or less, particularly preferably 500 ppm or less.

**11.** LED semiconductor body according to at least one of claims 1 to 10, wherein the semiconductor body (1) is arranged on a carrier (70), the carrier (70) being different from a growth substrate of the semiconductor body (1).

**12.** LED semiconductor body according to claim 11, wherein a mirror layer (72) is arranged between the carrier (70) and the semiconductor body (1), wherein the mirror layer (72) is metallic.

**13.** LED semiconductor body according to at least one of claims 1 to 12, wherein the quantum structure (2) is intended to produce radiation with a peak wavelength in the wavelength range between 750 nm and 1050 nm inclusive.

14. LED semiconductor body according to at least one of claims 1 to 13, wherein the quantum structure is designed such that a width at half maximum of the spectrum of the radiation produced by the quantum structure (2) is 70 nm or less, preferably 60 nm or less, and particularly preferably 50 nm or less.

15. LED semiconductor body according to at least one of claims 1 to 14, wherein the quantum structure (2) comprises 4 or more quantum layers (3), preferably 10 or more quantum layers.

**Revendications**

1. Corps semiconducteur à diode électroluminescente (DEL) (1) comprenant une série de couches semiconductrices, laquelle comprend une structure quantique (2) qui est prévue en vue de la production d'un rayonnement incohérent, avec au moins une couche quantique (3) et au moins une couche de barrage (4) ; dans lequel la couche quantique (3) et la couche de barrage (4) sont contraintes au moyen de signes algébriques qui sont mutuellement opposés ;
**caractérisé en ce que**
le corps semiconducteur à DEL (1) est fabriqué sous la forme d'un corps semiconducteur à couches minces.

2. Corps semiconducteur à DEL selon la revendication 1, dans lequel la couche quantique (3) est contrainte par compression et la couche de barrage (4) est contrainte par traction.

3. Corps semiconducteur à DEL selon la revendication 1 ou 2, dans lequel la contrainte de la couche de barrage (4) est inférieure, en valeur absolue, à la contrainte de la couche quantique (3).

4. Corps semiconducteur à DEL selon la revendication 3, dans lequel le montant de la contrainte de la couche de barrage (4) présente une valeur comprise entre 0,2 inclus et 0,67 inclus du montant de la contrainte de la couche quantique (3).

5. Corps semiconducteur à DEL selon la revendication 3, dans lequel le montant de la contrainte de la couche de barrage (4) présente une valeur comprise entre 0,33 inclus et 0,5 inclus du montant de la contrainte de la couche quantique (3).

6. Corps semiconducteur à DEL selon au moins l'une des revendications 1 à 5, dans lequel le coefficient de l'épaisseur de la couche de barrage (4) par rapport à l'épaisseur de la couche quantique (3) est supérieur ou égal à 1, de manière préférée est supérieur ou égal à 1,5, de manière particulièrement préférée est supérieur ou égal à 2,5.

7. Corps semiconducteur à DEL selon au moins l'une des revendications 1 à 6, dans lequel la couche quantique (3) contient du $In_yGa_{1-y}As$, avec $0 \leq y \leq 0,5$ ; de manière préférée avec $0,05 \leq y \leq 0,3$ ; de manière particulièrement préférée avec $0,1 \leq y \leq 0,2$.

8. Corps semiconducteur à DEL selon au moins l'une des revendications 1 à 7, dans lequel la couche de barrage (4) contrainte contient du $Al_xGa_{1-x}As_{1-z}P_z$ avec $0,01 \leq x \leq 1$ ; de manière préférée avec $0,1 \leq x \leq 0,6$ ; de manière particulièrement préférée avec $0,2 \leq x \leq 0,4$ et/ou avec $0,1 \leq z \leq 0,5$ ; de manière préférée avec $0,03 \leq z \leq 0,3$ ; de manière particulièrement préférée avec $0,05 \leq z \leq 0,2$.

9. Corps semiconducteur à DEL selon au moins l'une des revendications 1 à 8, dans lequel la structure quantique (2) présente une autre couche quantique (3) et une autre couche de barrage (4) et l'autre couche quantique (3) et l'autre couche de barrage (4) sont également contraintes au moyen de signes algébriques qui sont mutuellement opposés.

10. Corps semiconducteur à DEL selon au moins l'une des revendications 1 à 9, dans lequel une contrainte moyenne de la structure quantique (2) s'élève à 2000 ppm ou moins, de manière préférée s'élève à 1000 ppm ou moins, de manière particulièrement préférée s'élève à 500 ppm ou moins.

11. Corps semiconducteur à DEL selon au moins l'une des revendications 1 à 10, dans lequel le corps semiconducteur (1) est disposé sur un support (70), lequel est différent d'un substrat de croissance du corps semiconducteur (1).

12. Corps semiconducteur à DEL selon la revendication 11, dans lequel une couche réfléchissante (72) est disposée entre le support (70) et le corps semiconducteur (1) ; dans lequel la couche réfléchissante (72) est fabriquée en métal.

13. Corps semiconducteur à DEL selon au moins l'une des revendications 1 à 12,
dans lequel la structure quantique (2) est prévue en vue de la génération d'un rayonnement avec une longueur d'onde de pic qui se trouve dans une plage de longueur d'onde comprise entre 750 nm inclus et 1050 nm inclus.

14. Corps semiconducteur à DEL selon au moins l'une des revendications 1 à 13,
dans lequel la structure quantique (2) est fabriquée de telle sorte qu'une largeur à mi-hauteur du spectre du rayonnement généré par la structure quantique (2) s'élève à 70 nm ou moins, de manière préférée s'élève à 60 nm ou moins, de manière particulièrement préférée s'élève à 50 nm ou moins.

15. Corps semiconducteur à DEL selon au moins l'une des revendications 1 à 14,
dans lequel la structure quantique (2) présente quatre couches quantiques (3) ou plus, de manière préférée présente dix couches quantiques ou plus.

# FIG 1

FIG 2

EP 2 047 527 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006035627

- US 20040017835 A1

**In der Beschreibung aufgeführte Nicht-Patentliteratur**

- **I. SCHNITZER et al.** *Appl. Phys. Lett.,* 18. Oktober 1993, vol. 63 (16), 2174-2176